# EUROPEAN PATENT APPLICATION

(11) **EP 4 645 673 A1**
(43) Date of publication of application: **05.11.2025**
(21) Application number: 23912210.4
(22) Date of filing: 26.12.2023
(51) Int. Cl.: H02N 13/00, B25J 15/06, H01L 21/677, H01L 21/683

(54) **ELECTROSTATIC CHUCK**

(30) Priority: 28.12.2022 JP 2022212754
(71) Applicant: Creative Technology Corporation, Kawasaki-shi, Kanagawa 213-0034 (JP)
(72) Inventor: HASEGAWA Takaaki, Kawasaki-shi, Kanagawa 213-0034 (JP); ISHIBASHI Kazuya, Kawasaki-shi, Kanagawa 213-0034 (JP)
(74) Representative: Winter, Brandl - Partnerschaft mbB
(86) International application number: PCT/JP2023/046818
(87) International publication number: WO 2024/143432

(57) **Abstract**

An electrostatic chuck 101 having a unipolar structure includes: a dielectric body 2 including an electrode 23 and a dielectric layer 25 that covers the electrode 23 and has a volume resistivity of 10⁹ to 10¹³ Ω·cm; and a dechucking mechanism including a dechucking member 1 that is a conductor, in which the dechucking member 1 is connected to ground and is a counter electrode of the electrode 23.

## Description

### Technical Field

The present invention relates to an electrostatic chuck for attracting (adsorbing) an attraction target (workpiece), which can be used for a robot arm, a fixing jig, or the like.

### Background Art

In the related art, an electrostatic chuck is mainly used in a semiconductor manufacturing apparatus. An attraction type of the electrostatic chuck is roughly divided into three types: a Coulomb force type, a Johnsen-Rahbeck force type, and a gradient force type. Attraction forces generated by electrostatic chucks including a Coulomb force, a gradient force, and a Johnsen-Rahbek force do not act independently to attract an attraction target for each attraction type. That is, the attraction types are different in the balance of three types of attraction forces, and are classified depending on which attraction force mainly acts on the attraction target.

In general, a Coulomb force-type electrostatic chuck refers to an electrostatic chuck that includes a dielectric layer having a volume resistivity of 10¹⁴ Ω·cm or more and uses a unipolar or bipolar charging method.

As a simple understanding of the Coulomb force mainly generated in the Coulomb-type electrostatic chuck, in a configuration in which a first electrode, a dielectric layer, and an attraction target are arranged side by side, by replacing the attraction target with a second electrode in a pseudo manner, the configuration is regarded as a so-called capacitor consisting of the first and second electrodes arranged in parallel and a dielectric between the first and second electrodes. When a voltage is applied to the first and second electrodes, a force F that attracts the first and second electrodes to each other is generated by energy of an electric field generated between the first and second electrodes.

From a basic principle of the capacitor, the attracting force F can be expressed as F = 1/2 · V² · S · ε/D². That is, the attracting force F is proportional to the square of a potential difference V between the first and second electrodes, inversely proportional to the square of a distance D between the electrodes, and proportional to an electrode area S and a relative permittivity ε between the first and second electrodes.

Considering the attracting force F as the attraction force in the electrostatic chuck, it is understood that the attraction force is stronger as the applied voltage is higher, a thickness of the dielectric layer is smaller, the relative permittivity ε of the dielectric layer is higher, and the voltage for charging an object to be attracted is higher.

From the above, it is preferable to use a material with a high dielectric constant and a high dielectric breakdown strength, such as polyimide, for the dielectric layer of the Coulomb-type electrostatic chuck.

A Johnsen-Rahbeck force-type electrostatic chuck refers to an electrostatic chuck that includes a dielectric layer with a volume resistivity in a range of 10⁹ to 10¹³ Ω·cm and uses a bipolar charging method.

In the Johnsen-Rahbeck force-type electrostatic chuck, a dominant Johnsen-Rahbeck force is exhibited based on a capacitor-like attraction principle, similar to the Coulomb force. As a simple understanding, it can be considered that, when a voltage is applied to an internal electrode, a very small current flows from a back surface of an dielectric layer in contact with the internal electrode due to a low volume resistivity, and reaches a front surface of the dielectric layer, so that the front surface of the dielectric layer becomes a virtual electrode, and a force for attracting the internal electrode and the virtual electrode to each other is generated by energy stored by a sudden change in potential caused by a contact resistance at a small distance between the object to be attracted and the virtual electrode. That is, although an attraction force generated by the Johnsen-Rahbeck force-type electrostatic chuck is inversely proportional to the square of the distance between the electrodes, the attraction force generated by the Johnsen-Rahbeck force-type electrostatic chuck is larger than the attraction force generated by the Coulomb force-type electrostatic chuck because the distance between the electrodes is infinitely small.

However, since the potential continues to be supplied to the object to be attracted when a slight current flows into the object to be attracted, a potential difference between the electrode and the object to be attracted continues to decrease and the attraction force decreases when the unipolar charging method is adopted. Therefore, in general, the bipolar charging method is used in the Johnsen-Rahbeck force-type electrostatic chuck. In addition, since a charge has a (current) characteristic of moving to a place where the volume resistivity is low, the charge does not move to an object with a volume resistivity higher than the volume resistivity of the dielectric layer. For this reason, the Johnsen-Rahbeck force-type electrostatic chuck is only suitable for an attraction target having a characteristic of lower volume resistivity than that of the dielectric layer.

Finally, a gradient force-type electrostatic chuck adopts a bipolar charging method, and has a configuration in which positive (+) and negative (-) electrodes have a comb-like pattern and are alternately arranged. With this configuration, a non-uniform electric field is more likely to occur near the dielectric layer. A gradient force that is mainly exhibited in the gradient force-type electrostatic chuck is a gradient force by which an object to be attracted is attracted to an electrode side having a strong electric field intensity in a non-uniform electric field between the positive and negative electrodes. While the object to be attracted is dielectrically polarized in the electric field by the gradient force, the object to be attracted is attracted to the electrode having a strong electric field intensity by Coulomb's law.

Since the gradient force increases when electric field lines in the non-uniform electric field are concentrated, the attraction force by the gradient-type electrostatic chuck can be increased by shortening a distance between the positive and negative electrodes. In general, in an electrostatic chuck including plate-shaped electrodes, since the electrodes are horizontally arranged, the closer the positive and negative electrodes are arranged in a comb-like pattern, the stronger the attraction force of the gradient-type electrostatic chuck becomes.

In addition, since the lines of electric force are concentrated as the distance between the positive and negative electrodes disposed apart from each other in a horizontal direction and the object to be attracted is shorter, the attraction force of the electrostatic chuck can be increased by thinning the dielectric layer. Therefore, when the distance between the electrodes and the object to be attracted is reduced, it is preferable to select a dielectric layer with a relatively high volume resistivity and a high dielectric breakdown strength in order to maintain insulation from the electrodes.

As is clear from the above description, in the Coulomb force-type electrostatic chuck or the Johnsen-Rahbeck force-type (JR-type) electrostatic chuck, since a high voltage is used, a non-uniform electric field is generated between the electrodes, and a gradient force is also exhibited, and it is very difficult to exactly calculate the attraction force. Similarly, also in the gradient force-type electrostatic chuck, the attraction target in contact with the dielectric layer is attracted according to the principle of the capacitor as described above regarding the Coulomb force, and it is very difficult to exactly calculate the attraction force.

In general, when an object to be attracted and fixed is a conductor or a semiconductor, an attraction force per unit area of the object to be attracted is the strongest in the JR-type electrostatic chuck when the voltages are the same. Therefore, the JR-type electrostatic chuck is suitable for the application of attracting and fixing an object to be attracted with a relatively small contact area, which is a conductor or semiconductor, such as a small or slender workpiece (hereinafter referred to as a small workpiece).

The electrostatic chucks are beginning to be used in applications other than the semiconductor manufacturing apparatus when traditional fixed conveyance methods such as vacuums (suction devices) and robot hands are not sufficient. However, the known electrostatic chucks are limited in cost and takt time (speed of attraction and release) and do not provide the performance desired by users, and it is difficult to introduce the known electrostatic chuck.

For example, in a vacuum device that attracts and holds an attraction target using a differential pressure with an atmospheric pressure, when the attraction target is a metal mesh or fabric, air may escape from a gap between an attraction pad that supplies a negative pressure and the attraction target, and it is difficult to pick up the attraction target.

In addition, a robot hand that has a pair of claws and grips a gripping target with the claws is used. However, the robot hand avoids gripping the metal mesh or the fabric. This is because, when the gripping target has a low-strength portion such as a mesh hole of the metal mesh or a fabric grain, the gripping target to be gripped may be deformed or wrinkled.

Further, since the use of the vacuum device for conveying a large number of small workpieces requires a vacuum hole for supplying a negative pressure for each small workpiece, it is not practical to use the vacuum device to convey a large number amount of small workpieces. On the other hand, when the robot hand is used to convey a large number of small workpieces, it is necessary to pick up the small workpieces one by one with a pair of claws, and thus it is difficult to shorten a conveyance time.

### Citation List

### Patent Literature

Patent Literature 1: Japanese Patent Application No. 2003-401841
Patent Literature 2: Japanese Patent Laid-Open No. 2004-031599

### Summary of Invention

### Technical Problem

The electrostatic chuck can convey a large number of small workpieces that are difficult to be conveyed by a vacuum device or a robot hand. Considering attraction characteristics of the electrostatic chuck described above, it has been found that the Coulomb type or the JR type is preferable when the metal mesh is attracted and conveyed, the Coulomb type or the gradient type is preferable when the cloth is attracted and conveyed, and the JR type or the gradient type is preferable when the small workpiece is attracted and conveyed.

However, in the Coulomb type and gradient type, since a material such as polyimide with a high volume resistance is used for a dielectric layer, there is a problem that it is difficult to lower a potential from the dielectric layer.

In addition, since the attraction target undergoes dielectric polarization during attraction, the attraction force of an attraction surface tends to remain for a long time even after a power supply of the electrostatic chuck is turned off. Therefore, there is a problem that the remaining attraction force acts on an attraction target having a light weight such as a small part, and dechucking for separating the attraction target from the attraction surface is difficult.

On the other hand, the known JR type has characteristics that the potential is more likely to decrease than the potential in the Coulomb type and the gradient type, and a dechucking time until the attraction target is released from the attraction surface can be relatively shortened. However, in the known JR type, it is difficult to further shorten the dechucking time. Further, when a dimension of the attraction target is further minimized, there is a problem that the attraction target cannot straddle the positive and negative electrodes and is not attracted, and as a result, the attraction target may not be reliably conveyed.

Patent Literature 1 discloses a JR-type electrostatic chuck related to the above problem. The electrostatic chuck of Patent Literature 1 has a unipolar structure in which a charge is applied to a wafer by plasma discharge in order to hold the wafer on a chuck body. However, in order to hold the wafer, the electrostatic chuck is limited to an application of wafer processing using plasma discharge.

Patent Literature 2 discloses an electrostatic chuck on which an insulating substrate such as a wafer is placed. The electrostatic chuck has a configuration in which a unipolar electrostatic electrode is exposed on a placement surface on which an insulating substrate is placed. Therefore, an attraction target of the electrostatic chuck of Patent Literature 2 can be used only when a surface thereof is an insulator, and the use of the electrostatic chuck is limited, so that the conductor through which a current flows cannot be attracted.

As described above, in the electrostatic chuck in the related art, the electrostatic chuck capable of reliably chucking and dechucking a large number of small workpieces has problems such as an increase in introduction cost, limitation of an attraction target, and an increase in size of equipment.

Therefore, an object of the present invention is to provide an electrostatic chuck that is inexpensive, has high versatility, and has excellent chucking characteristics and dechucking characteristics without increasing a size and complexity of equipment.

### Solution to Problem

The inventors have focused on the fact that a physical dechucking mechanism necessarily comes into contact with an attraction (adsorption) target, and have provided an electrostatic chuck for solving the above problem.

In a first aspect of an electrostatic chuck of the present invention, an electrostatic chuck having a unipolar structure includes:
a dielectric body including an electrode and a dielectric layer that covers the electrode and has a volume resistivity of 10⁹ to 10¹³ Ω·cm; and
a dechucking mechanism including a dechucking member that is a conductor, in which
the dechucking member is connected to ground and is a counter electrode of the electrode.

The dechucking member is a conductor connected to the ground and functions as a counter electrode for the electrostatic chuck, and thus a JR-type electrostatic chuck can attract an attraction target.

A second aspect of the electrostatic chuck of the present invention is the electrostatic chuck according to the first aspect, in which the dielectric body is disposed above the dechucking member in a vertical direction.

A third aspect of the electrostatic chuck of the present invention is the electrostatic chuck according to the first or second aspect, in which the dechucking member is a metal mesh.

A fourth aspect of the electrostatic chuck of the present invention is the electrostatic chuck according to the third aspect, in which a thickness of the mesh is 20 µm to 100 µm.

A fifth aspect of the electrostatic chuck of the present invention is the electrostatic chuck according to the first or second aspect, in which the dechucking member and the dielectric layer are arranged side by side in one direction.

A sixth aspect of the electrostatic chuck of the present invention is the electrostatic chuck according to the first aspect, in which the dechucking mechanism includes a drive unit configured to drive the dechucking member, and the drive unit is a motor or a power cylinder.

A seventh aspect of the electrostatic chuck of the present invention is the electrostatic chuck according to the second aspect, in which the dechucking member has elasticity and functions as a drive unit configured to drive the dechucking member, or the dechucking mechanism has a spring connected to the dechucking member.

Since a Coulomb force contributing to an attraction force is inversely proportional to the square of the thickness of the mesh, the thickness of the mesh is preferably thin. As a result of diligent verification, the inventors have found that a desired attraction force cannot be obtained when the maximum thickness of the mesh is larger than 100 µm. When the thickness of the mesh is less than 20 µm, the mesh may be twisted during dechucking or the mesh may be wrinkled during attraction.

### Therefore, the thickness is preferably 20 µm or more.

The mesh means a shape having a plurality of micropores.

In the seventh aspect of the electrostatic chuck of the present invention, the electrostatic chuck according to the second aspect includes a drive unit configured to drive the dechucking mechanism or the dielectric body, in which the drive unit is a motor or a power cylinder. The motor includes an electric motor such as a DC motor, a direct current motor, a servo motor, or a stepping motor, and the power cylinder includes an actuator that can be extended or retracted by hydraulic pressure, air pressure, water pressure, or the like.

### Advantageous Effects of Invention

In a JR-type electrostatic chuck in the related art, in order to realize a bipolar charging method, a configuration for providing a special charge supply unit is required, and the electrostatic chuck tends to be complicated. However, the present invention adopts a unipolar charging method, and thus the structure can be simplified. According to the electrostatic chuck of the present invention, since the counter electrode also serves as a dechucking mechanism, the configuration can be simplified and the cost can be reduced. In addition, since the present invention has a unipolar structure, the attraction target can reliably come into contact with the dechucking members of both electrodes.

Further, according to the present invention, even when unexpected peeling electrification or the like occurs during the operation of the physical dechucking mechanism, since the volume resistivity of the dielectric layer is relatively low, static electricity can be removed by the charge transfer. Therefore, the attraction force of the electrostatic chuck does not decrease. Further, since the electrostatic chuck of the present invention does not require a discharging mechanism, the components can be simplified and the cost can be reduced.

In addition, when the attraction target is a conductor, since a current flows to the counter electrode and the attraction target without passing through the dielectric layer, a voltage drop does not occur, and an attraction force is not generated at a portion where the attraction target and the counter electrode come into contact with each other. However, as compared with a configuration in which the dielectric layer is provided on the counter electrode, the current flows well, and thus only slight contact between the attraction target and the counter electrode is sufficient. Therefore, it is possible to realize an electrostatic chuck having excellent versatility, chucking characteristics, and dechucking characteristics.

According to the second aspect of the electrostatic chuck, when the voltage is applied to the electrostatic chuck, a dechucking portion is pulled toward the dielectric body by a gradient force, so that the dechucking mechanism can be simplified.

Furthermore, according to the seventh aspect of the electrostatic chuck, when the dechucking member is installed at a position slightly away from the dielectric body with a tension weaker than the gradient force, by utilizing the flexure of the dechucking member itself or the spring, the operation of attaching or peeling the dechucking member to or from the dielectric body can be executed by the gradient force depending on whether the voltage is applied.

### Brief Description of Drawings

[Figure 1] Figure 1 schematically illustrates an electrostatic chuck according to a first embodiment of the present invention.
[Figure 2] Figure 2 is a partial cross-sectional view of a main part of the electrostatic chuck of Figure 1, in which (a) illustrates a chucked state of an attraction target, and (b) illustrates a dechucked state of the attraction target.
[Figure 3] (a) is a plan view of a dielectric body and an electrode of the electrostatic chuck illustrated in Figure 1, and (b) is a plan view of a dechucking member of the electrostatic chuck illustrated in Figure 1.

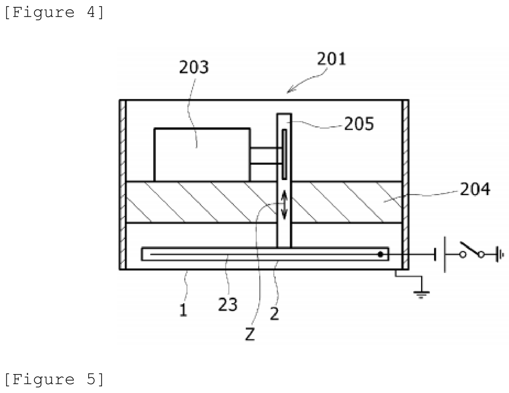

[Figure 4] Figure 4 schematically illustrates an electrostatic chuck according to a second embodiment of the present invention.
[Figure 5] (a) schematically illustrates an electrostatic chuck according to a third embodiment, and (b) schematically illustrates an electrostatic chuck according to a fourth embodiment.

### Description of Embodiments

Hereinafter, embodiments and examples of the present invention will be described with reference to the drawings. The present invention is not limited to the present embodiments. In the following description, the same components are denoted by the same reference numerals, and the description thereof will be omitted or simplified.

### (First Embodiment)

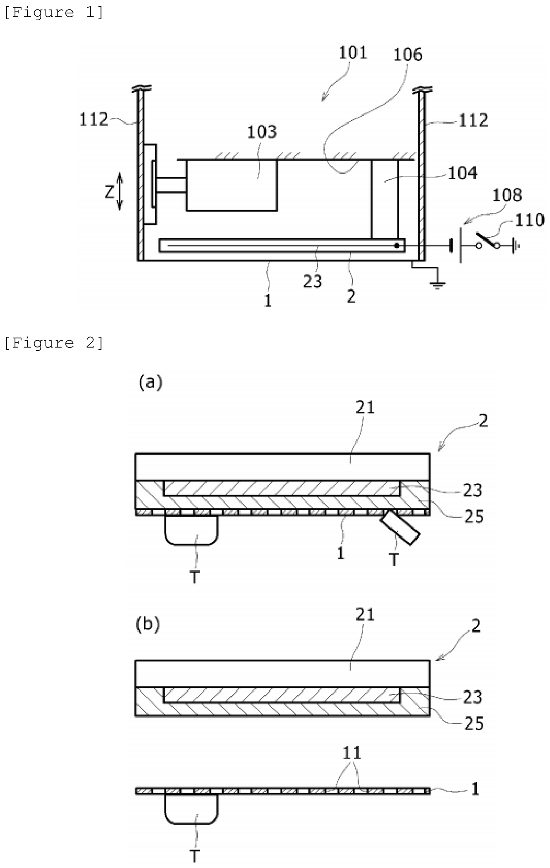

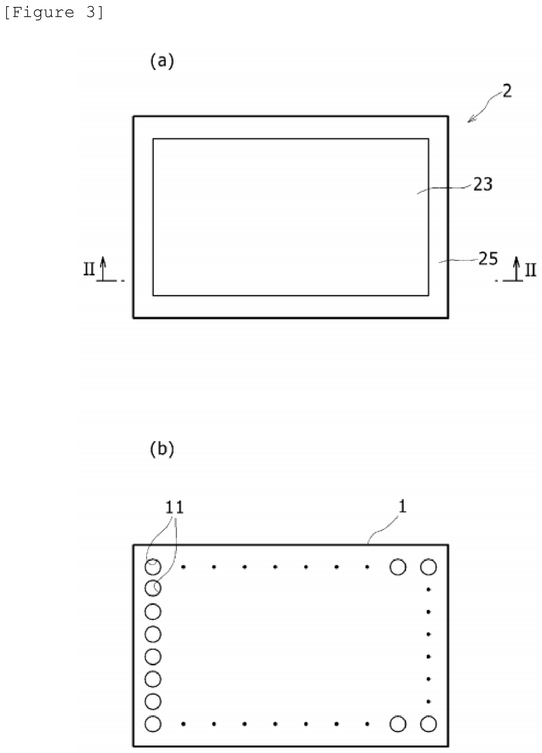

Figure 1 schematically illustrates an electrostatic chuck 101 according to a first embodiment of the present invention, Figure 2 is a partial cross-sectional view of a main part of the electrostatic chuck 101 of Figure 1, Figure 2(a) illustrates a chucked state in which an attraction target T is attracted (adsorbed) , Figure 2 (b) illustrates a dechucked state in which the attraction target T is removed, Figure 3(a) is a plan view of an electrode 23 of a dielectric body 2 of the electrostatic chuck 101 illustrated in Figure 1, and Figure 3(b) is a plan view of a dechucking member 1 of the electrostatic chuck 101 illustrated in Figure 1.

The electrostatic chuck 101 mainly includes a dechucking mechanism and the dielectric body 2. As illustrated in Figure 2, the dielectric body 2 has a laminated structure, and includes an insulating layer 21, an electrode 23 laminated on the insulating layer 21, and a dielectric layer 25 that completely covers the electrode 23 and is laminated on the insulating layer 21. The dechucking mechanism includes the dechucking member 1, a unit that moves or drives the dechucking member 1, a support member that supports the dechucking member 1, and the like. The dechucking mechanism of the present embodiment includes a lifting unit 112 to which the dechucking member 1 is connected, and an electric motor 103 that drives the lifting unit 112.

An insulator with a volume resistivity of 1.0 x 10⁹ to 1.0 x 10¹³ Ω·cm is used for the dielectric layer 25 of the dielectric body 2. Examples thereof include ceramic, soft polyvinylchloride (PVC), paper phenol (a material in which paper is impregnated with a phenol resin), polyacetal, a glass epoxy resin (a material in which glass fibers are impregnated with a liquid epoxy resin and thermally cured), conductive polyethylene (PE), polyurethane, ethylene-vinyl acetate (EVA), an insulating resin with a kneaded conductor and an adjusted volume resistivity, or the like.

The electrode 23 is made of a conductive material. As illustrated in Figure 3(a), the electrode 23 of the present embodiment has a planar shape in the plan view. Needless to say, the shape of the electrode 23 can be appropriately changed according to a shape of the insulating layer 21 to be laminated. The electrode 23 is connected to a negative electrode of a power supply 108 that generates a DC voltage. Therefore, when a switch 110 is turned on, a negative DC voltage is applied to the electrode 23.

The dielectric layer 25 is made of a material with a volume resistivity higher than a volume resistivity of the attraction target T. The amount of charge moving through the dielectric layer 25 increases as a volume resistivity of the dielectric layer 25 decreases, and a generated JR force can be increased.

A volume resistivity of the insulating layer 21 needs to be equal to or greater than the volume resistivity of the dielectric layer 25. The inventors have found that the volume resistivity of the insulating layer 21 is preferably 1.0 x 10¹⁵ Ω·cm or more, and more preferably 1.0 x 10¹⁸ Ω·cm or more.

When the volume resistivity of the insulating layer 21 is less than the volume resistivity of the dielectric layer 25, a charge does not move to the dielectric layer 25 side and the charge moves to the insulating layer 21 side, and thus the dielectric layer 25 cannot accumulate the charge. As a result, the electrostatic chuck 101 cannot exhibit the attraction force and cannot attract the attraction target.

The higher the flatness of the dielectric layer 25 is, the larger a contact area with the attraction target T can be made. Thus, it is preferable to fabricate the dielectric body 2 by hot press processing for thermocompression bonding or lamination processing for bonding.

As illustrated in Figure 3(b), the dechucking member 1 of the dechucking mechanism is made of a metal thin film provided with a plurality of openings 11. The dechucking member 1 is fixed to a housing 106 of the electrostatic chuck 101 via a fixing member 104. The dechucking member 1 is grounded. By setting a diameter of each of the openings 11 to be smaller than a dimension of the attraction target T, a contact point between the attraction target T and the dechucking member 1 can be secured, and attraction can be reliably realized.

A thickness of the metal thin film is preferably reduced to shorten a distance to the attraction target T, and is preferably 100 µm or less, and more preferably 60 µm or less. This is because a gradient force is inversely proportional to the square of the distance and becomes weak, and therefore, when the thickness of the metal thin film is greater than 100 µm, there is a concern that an attractive rate for the attraction target T assumed by the inventors or the like cannot be secured. Further, when the thickness of the metal thin film is less than 20 µm, the metal thin film may be twisted during dechucking or the metal thin film may be wrinkled during attraction, which may reduce a dechucking rate of the attraction target T.

The dechucking member 1 having the openings 11 is preferably formed by etching a metal thin film, laser processing, wire electrical discharge machining, electroforming, or the like. In contrast, when the openings of the metal thin film are formed by mechanical processing such as punching, portions around punched holes may be deformed into a convex shape or a concave shape, the contact between the attraction target T and the dechucking member 1 may be unstable, and the attraction target may not be stably attracted. It is not preferable to use, as the dechucking member, a wire mesh produced by weaving metal wire rods. This is because the wire mesh has a convex shape or a concave shape due to the intersection of the wire rods, and thus, similarly to the mechanical processing described above, the contact between the attraction target T and the dechucking member 1 may be unstable, and the attraction target may not be stably attracted.

In addition, the housing 106 is provided with an electric motor 103, and the electric motor 103 is connected to the lifting unit 112 via a mechanism (for example, rack and pinion) that converts a rotational force into a linear motion. The lifting unit 112 is movable in a Z direction (up-down direction in Figure 1) by the rotational force of the electric motor 103. The lifting unit 112 of the present embodiment includes a pair of members extending in the up-down direction in Figure 1 and disposed apart from each other in a left-right direction. The dechucking member 1 is connected to the lifting unit 112, and when a drive signal is received from a control unit (not illustrated), the dechucking member 1 is moved in the Z direction by the rotational force of the electric motor 103, and the dechucking member 1 abuts against the dielectric layer 25.

Since the dechucking member 1 functions as a grounded (0 V) counter electrode, a negative voltage is applied to the electrostatic chuck 101 in the present embodiment, but a positive voltage may be applied.

Figures 2(a) and 2(b) are schematic cross-sectional views illustrating functions and effects in an attraction process and a dechucking process when the electrostatic chuck 101 is used.

The attraction process of the present embodiment starts from a state in which the electric motor 103 is driven, the lifting unit 112 moves upward in the Z direction, and the dechucking member 1 is in contact with or close to the dielectric body 2. In this state, when the switch 110 of the power supply 108 provided in the electrostatic chuck 101 is turned on, the attraction process is started, and a predetermined DC voltage is applied to the electrode 23. This induces a negative (-) charge on the electrode 23 (see Figure 2(a)).

In this state, as illustrated in Figure 2(a), when the dechucking member 1, the insulating layer 21, and the dielectric layer 25 have the above-described volume resistivity characteristics, the attraction target T (T illustrated on the right side of Figure 2(a)) can be attracted to the dielectric layer 25.

At this time, the negative (-) charge is supplied from the electrode 23 to the dielectric layer 25, and the negative (-) charge moves to the dechucking member 1 of the dielectric layer 25. When the charge moves to the attraction target T, which has a voltage of 0 V, a sudden voltage drop occurs, an attraction force of a JR chuck type is generated on the dielectric layer 25, and the attraction target T (T illustrated on the right side of Figure 2(a)) is attracted.

Since the dechucking member 1 is connected to the ground, the charge that has moved to the attraction target T is discarded to the dechucking member 1, and the attraction target T is maintained at 0 V. As a result, a potential difference is maintained between the dielectric layer 25 and the attraction target T, which is sufficient to generate an attraction force for attracting the attraction target T.

Even if the attraction target T (T illustrated on the left side of Figure 2(a)) is not in contact with the dielectric layer 25, the attraction target T can be pulled toward the electrode 23 by a gradient force exhibited between the electrode 23 and the dechucking member 1 and thus can be retained on the electrostatic chuck (dechucking member 1).

Further, in the operation of the attraction process, the dechucking member 1 vibrates or swings, and a pressure or the like for pressing the attraction target T is applied to the attraction target T, so that the attraction target T is auxiliarily moved in a direction of a stronger electric field, and thus the attractive rate is exceptionally high.

When the attraction target T is a very small workpiece, the attraction target T (T illustrated on the left side of Figure 2(a)) can be attracted only by the gradient force described above. This is because the gradient force has a correlation with a surface area of the dielectric layer, and as a volume (weight) of the attraction target T decreases, the surface area increases relatively, and the gradient force increases relatively.

Since the gradient force is defined by a potential difference, even in a Coulomb-type or gradient-type electrostatic chuck using a dielectric layer with a volume resistivity of 1.0 x 10¹⁴ Ω ·cm or more, the attraction can be performed by the gradient force, and the dechucking can be performed by the same dechucking mechanism as in the present embodiment. However, when the attraction target is dechucked from the electrostatic chuck with the remaining attraction force, there is a problem that the attraction target is charged with an opposite potential by frictional electrification or peeling electrification, making repeated attraction operations impossible. In order to avoid this problem, it is necessary to prepare a special power supply capable of switching the polarity, and it is necessary to add a process of removing the charge stored on the dielectric layer each time the dechucking is performed. Therefore, the JR-type configuration is excellent.

Next, in the dechucking process, as illustrated in Figure 2(b), the electric motor 103 is driven, the lifting unit 112 moves downward in the Z direction, and the dechucking member 1 is separated from the dielectric body 2. In addition, when the switch 110 (see FIG. 1) is turned off, the application of the voltage to the electrode 23 is stopped, and the attraction target T is released from the dechucking member 1.

### [Examples]

The inventors have conducted a demonstration test of the attractive rate of the electrostatic chuck under the following conditions.

### (Demonstration Test 1)

The insulating layers 21 of Examples 1 and 2 are made of NC nylon, which is a resin material, and have a thickness of 5 mm.

The electrodes 23 of Examples 1 and 2 are made of a copper material and have a thickness of 7 µm.

The dielectric layer 25 of Example 1 was made of a polyacetal plate with a volume resistivity of 1.0 x 10¹³ Ω·cm and a thickness of 300 µm, and the dielectric layer 25 of Example 2 was made of soft PVC with a volume resistivity of 1.0 x 10⁹ Ω·cm and a thickness of 500 µm.

The dechucking member 1 (counter electrode) of the dechucking mechanism is a plate-shaped member in which a plurality of openings 11 with a diameter of 1 mm are provided at a pitch of 100 µm in a 20 µm SUS foil by etching. A pneumatic (air) cylinder was used as a drive unit of the dechucking member 1.

Further, as the attraction target T, 30 three-dimensional members with a dimension of 1.7 × 2.1 × 0.7 mm and a surface resistivity of 3 × 10⁻¹ Ω/sq were used. A voltage of 2.2 KV is applied from the power supply 108. In an environment with a room temperature of 22°C, a humidity of 30 to 35%, and an atmospheric pressure, three processes such as an attraction process of attracting the attraction target T by the electrostatic chuck 101, a movement process of moving the electrostatic chuck 101 while holding the attraction target T, and a dechucking process of releasing the attraction target T from the electrostatic chuck 101 were set as one cycle, and the three processes were continuously performed five times for 30 attraction targets T, and transitions in an attractive rate and a dechucking rate were confirmed. The time required for each of the attraction process, the movement process, and the dechucking process is 5 seconds. In the movement process, the electrostatic chuck 101 was moved on the plane from a first predetermined point to a second predetermined point with a required time of 5 seconds.

In the movement process, when an attraction target T fell, the attraction target T was excluded from the attraction targets T that could be attracted in the attraction process. Therefore, the attraction target T is not included in the number of attraction targets T released in the dechucking process.

### [Comparative Example]

In comparative examples, evaluation tests were performed using a dielectric layer with a volume resistivity of 1.0 x 10⁶ Ω·cm smaller than 1.00 x 10⁹ (Comparative Example 1) and a dielectric layer with a volume resistivity of 1.0 x 10¹⁸ Ω·cm larger than 1.00 x 10¹³ (Comparative Example 2).

From Demonstration Test 1, the following results (see Table 1) were obtained. In Example 1, the attractive rate was 99% on average for five times, and in Example 2, the attractive rate was 94% on average for five times, whereas in Comparative Example 1, the attractive rate was 0%, and in Comparative Example 2, the attractive rate was 48%. Therefore, it was confirmed that the electrostatic chucks according to the examples could achieve superior attracting properties as compared with Comparative Examples 1 and 2.

**[Table 1]**

| N-th Test | Volume Resistivity (Ω·cm) of Dielectric Layer | | | |
|---|---|---|---|---|
| | Comparative Example 1 (10⁶) | Example 2 (10⁹) | Example 1 (10¹³) | Comparative Example 2 (10¹⁸) |
| 1 | 0% | 100% | 97% | 100% |
| 2 | 0% | 93% | 100% | 50% |
| 3 | 0% | 93% | 100% | 43% |
| 4 | 0% | 93% | 100% | 27% |
| 5 | 0% | 90% | 100% | 20% |
| Average | 0% | 94% | 99% | 48% |

### (Demonstration Test 2)

The insulating layer 21 is made of NC nylon, which is a resin material, and has a thickness of 5 mm.

The electrode 23 is made of a copper material and has a thickness of 7 µm.

As the dielectric layer 25, a polyacetal plate with a volume resistivity of 1.0 x 10¹³ Ω·cm and a thickness of 300 µm was used.

The dechucking member 1 (counter electrode) of the dechucking mechanism is a plate-shaped member in which a plurality of openings 11 with a diameter of 1 mm are provided at a pitch of 100 µm in SUS foils of 20 µm, 60 µm, 100 µm, and 200 µm by etching. A pneumatic (air) cylinder was used as a drive unit of the dechucking member 1.

Further, as the attraction target T, 30 three-dimensional members with a dimension of 1.7 × 2.1 × 0.7 mm and a surface resistivity of 3 × 10⁻¹ Ω/sq were used. A voltage of 2.2 KV is applied from the power supply 108. In an environment with a room temperature of 22°C, a humidity of 30 to 35%, and an atmospheric pressure, three processes such as an attraction process of attracting the attraction target T by the electrostatic chuck 101, a movement process of moving the electrostatic chuck 101 while holding the attraction target T, and a dechucking process of releasing the attraction target T from the electrostatic chuck 101 were set as one cycle, and the three processes were continuously performed five times for 30 attraction targets T, and transitions in an attractive rate and a dechucking rate were confirmed. The time required for each of the attraction process, the movement process, and the dechucking process is 5 seconds. In the movement process, the electrostatic chuck 101 was moved on the plane from a first predetermined point to a second predetermined point with a required time of 5 seconds.

In the movement process, when an attraction target T fell, the attraction target T was excluded from the attraction targets T that could be attracted in the attraction process. Therefore, the attraction target T is not included in the number of attraction targets T released in the dechucking process.

From Demonstration Test 2, the following results were obtained (see Table 2). The attractive rate was 100% on average for five times in a case of 20 µm, the attractive rate was 99% on average for five times in a case of 60 µm, and the attractive rate was 86% on average for five times in a case of 100 µm, whereas the attractive rate was 17% on average for five times in a case of 200 µm. Therefore, it was confirmed that the electrostatic chucks according to the examples could achieve superior attracting properties in the case of 20 µm to 100 µm.

**[Table 2]**

| N-th Test | Thickness of Dechucking Member (µm) | | | |
|---|---|---|---|---|
| | 20 | 60 | 100 | 200 |
| 1 | 100% | 97% | 87% | 17% |
| 2 | 100% | 100% | 97% | 27% |
| 3 | 100% | 100% | 90% | 3% |
| 4 | 100% | 100% | 80% | 13% |
| 5 | 100% | 100% | 77% | 27% |
| Average | 100% | 99% | 86% | 17% |

Needless to say, the material of the dielectric layer used in the demonstration tests 1 and 2 can be appropriately changed. This is because the same results as in the demonstration tests 1 and 2 can be obtained as long as a member has a desired volume resistivity.

### [Second Embodiment]

Unlike a drive unit 103 of the first embodiment, a drive unit 203 included in an electrostatic chuck 201 of the second embodiment is configured to move a support unit 205 in an arrow Z direction (up-down direction). The dielectric body 2 is connected to the support unit 205, and the dielectric body 2 can be brought into contact with or separated from the dechucking member 1 by the drive unit 203. Further, the drive unit 203 is disposed in a housing 204 of the electrostatic chuck 201.

The configuration and operation of the electrostatic chuck 201 of the second embodiment are the same as those of the first embodiment. As described in the first and second embodiments, the configuration of the drive unit can be appropriately changed as long as the drive unit can relatively move the dechucking member 1 and the dielectric body 2 in an approaching direction and a separating direction. Further, an electric motor or a power cylinder can be appropriately selected as the drive unit in the first and second embodiments and the embodiments described later.

### [Third Embodiment]

Unlike the drive unit 103 of the first embodiment, a drive unit 303 of the third embodiment does not include a power cylinder and a motor. In the drive unit 303, a dechucking member 302 is mounted on a housing 112 of an electrostatic chuck 301 via a spring 303. The spring 303 having an elastic force weaker than a Coulomb force by which the dechucking member 302 (for example, a metal mesh) is attracted upward in the Z direction by applying a voltage from the power supply 108 is used. When the power supply 108 is turned off in the dechucking process, the Coulomb force by the electrostatic chuck 301 does not act, and the dechucking member 302 is released from the dielectric body 2 by the elastic force of the spring 303. That is, the spring 303 extends downward in the Z direction and returns to an initial position.

According to the third embodiment, the configuration of the electrostatic chuck 301 can be simplified and the cost can be reduced.

### [Fourth Embodiment]

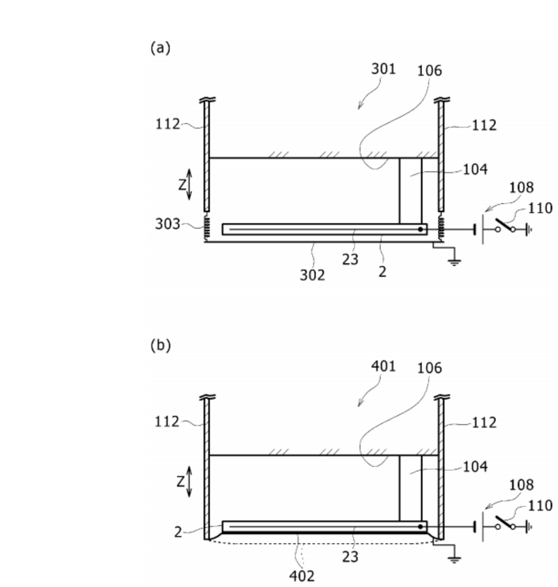

Unlike the drive unit 103 of the first embodiment, a drive unit of the fourth embodiment does not include a power cylinder and a motor. Figure 5(b) schematically illustrates an electrostatic chuck 401 according to the fourth embodiment.

Further, in a drive unit 402 of the fourth embodiment, a dechucking member 402 is mounted on the housing 112 of the electrostatic chuck 401 as in the first embodiment. The dechucking member 402 of the fourth embodiment is different from the dechucking member 1 of the first embodiment in that the dechucking member 402 is formed of a member with a predetermined elastic force. The dechucking member 402 (for example, a metal mesh) is formed of a member with an elastic force weaker than a Coulomb force by which the dechucking member 402 is attracted (upward in the Z direction) when a voltage is applied by the power supply 108. That is, when the power supply is turned off in the dechucking process, the Coulomb force by the electrostatic chuck 401 does not act on the dechucking member 402, and the dechucking member 402 is released from the dielectric body 2 by the elastic force of the dechucking member 402. That is, when the power supply 108 is turned on, the dechucking member 402 comes into contact with the dielectric body 2 while being bent upward in the Z direction, and when the power supply 108 is turned off, the dechucking member 402 is bent downward in the Z direction and is separated from the dielectric body 2.

According to the fourth embodiment, the configuration of the electrostatic chuck 401 can be simplified and the cost can be reduced as compared with the electrostatic chuck 301 of the third embodiment.

Although the dechucking member 1 and the dielectric body 2 are arranged to face each other in a vertical direction in the above embodiments and examples, the electrostatic chuck of the present invention is not limited to this configuration. For example, a positional relationship between the dechucking member 1 and the dielectric body 2 may be within a range in which the dechucking mechanism can physically hook and peel off the attraction target. Therefore, the dechucking member 1 and the dielectric body 2 can be arranged side by side in a horizontal direction, or can be arranged parallel to each other in a direction inclined with respect to the horizontal direction, that is, in one direction.

### Reference Signs List

- 1, 302, 402: dechucking member
- 2: dielectric body
- 101, 201, 301, 401: electrostatic chuck
- 103, 203, 303: electric motor (drive unit)
- 104: fixing member
- 106, 204: housing
- 108: power supply
- 110: switch
- 112: lifting unit/housing
- 205: support unit
- T: attraction target

## Claims

1. An electrostatic chuck having a unipolar structure, the electrostatic chuck comprising:
a dielectric body including an electrode and a dielectric layer that covers the electrode and has a volume resistivity of 10⁹ to 10¹³ Ω·cm; and
a dechucking mechanism including a dechucking member that is a conductor, wherein
the dechucking member is connected to ground and is a counter electrode of the electrode.

2. The electrostatic chuck according to claim 1, wherein
the dielectric body is disposed above the dechucking member in a vertical direction.

3. The electrostatic chuck according to claim 1 or 2, wherein
the dechucking member is a metal mesh.

4. The electrostatic chuck according to claim 3, wherein
a thickness of the mesh is 20 µm to 100 µm.

5. The electrostatic chuck according to claim 1 or 2, wherein
the dechucking member and the dielectric layer are arranged side by side in one direction.

6. The electrostatic chuck according to claim 1, wherein
the dechucking mechanism includes a drive unit configured to drive the dechucking member, and the drive unit is a motor or a power cylinder.

7. The electrostatic chuck according to claim 2, wherein
the dechucking member has elasticity and functions as a drive unit configured to drive the dechucking member, or the dechucking mechanism has a spring connected to the dechucking member.

## Amended claims

### Amended claims under Art. 19.1 PCT

1. An electrostatic chuck having a unipolar structure, the electrostatic chuck comprising:
a dielectric body including an electrode and a dielectric layer that covers the electrode and has a volume resistivity of 10⁹ to 10¹³ Ω·cm; and
a dechucking mechanism including a dechucking member including a face contacting with the dielectric layer and being a conductor, wherein
the dechucking member is connected to ground and is a counter electrode of the electrode, and
the dechucking member including another face different from the face, the another face attracting an attraction target.

2. The electrostatic chuck according to claim 1, wherein
the dielectric body is disposed above the dechucking member in a vertical direction.

3. The electrostatic chuck according to claim 1 or 2, wherein
the dechucking member is a metal mesh.

4. The electrostatic chuck according to claim 3, wherein
a thickness of the mesh is 20 µm to 100 µm.

5. The electrostatic chuck according to any of claims 1 to 4, wherein
the dechucking member and the dielectric layer are arranged side by side in one direction.

6. The electrostatic chuck according to any of claims 1 to 5, wherein
the dechucking mechanism includes a drive unit configured to drive the dechucking member, and the drive unit is a motor or a power cylinder.

7. The electrostatic chuck according to any of claims 1 to 6, wherein
the dechucking member has elasticity and functions as a drive unit configured to drive the dechucking member, or the dechucking mechanism has a spring connected to the dechucking member.
